# EUROPÄISCHE PATENTANMELDUNG

(11) **EP 1 936 388 A1**
(43) Veröffentlichungstag der Anmeldung: **25.06.2008**
(21) Anmeldenummer: 07023753.2
(22) Anmeldetag: 07.12.2007
(51) Int. Cl.: G01R 1/20, H01C 1/14, H01R 11/28

(54) **Elektrisches Leitermaterial mit Messwiderstand**

(30) Priorität: 22.12.2006 DE 102006061260; 22.03.2007 DE 102007013806
(71) Anmelder: Wieland-Werke AG, 89079 Ulm (DE)
(72) Erfinder: Ringhand, Dirk, Dr., 89584 Ehingen (DE); Kudashov, Dimitry, Dr., 89264 Weissendorn (DE); Scharf, Michael, 89165 Dietenheim (DE); Wiehler, Matthias, 89297 Roggenburg (DE)

(57) **Zusammenfassung**

Die Erfindung betrifft ein elektrisches Leitermaterial mit Messwiderstand (3), wobei der Messwiderstand mit dem übrigen Material des elektrischen Leiters als formschlüssiger Werkstoffverbund und/oder, bis auf die außen liegende Oberfläche (31), allseitig stoffschlüssig eingebunden ist, wobei im Betrieb der Stromfluss zumindest zum Teil über den Messwiderstand führt.

Des Weiteren betrifft die Erfindung diverse Verfahren zur Herstellung eines elektrischen Leitermaterials mit Messwiderstand.

## Beschreibung

Die Erfindung betrifft ein elektrisches Leitermaterial mit Messwiderstand gemäß dem Oberbegriff des Anspruchs 1 und ein Verfahren zur Herstellung eines elektrischen Leitermaterials gemäß dem Oberbegriff der Ansprüche 9 und 15 bis 17.

Aus der Druckschrift DE 10 2005 041 881 A1 ist eine Anschlusseinrichtung für eine Batterie mit einer direkt an einem Pol der Batterie anschließbaren Befestigungseinrichtung bekannt. Die Anschlusseinrichtung beinhaltet auch eine einen Messwiderstand umfassende Messeinrichtung für den Batteriestrom, bei der die Befestigungseinrichtung nur an einem einzigen Pol der Batterie angeschlossen wird und die Befestigungseinrichtung eine für Batterieanschlusskabel im Kraftfahrzeug übliche Polklemme aufweist. Der Messwiderstand ist im Wesentlichen ringförmig ausgebildet und zwischen der Polklemme und dem Pol angeordnet, so dass der Stromfluss zwischen dem Pol und der Polklemme über den Messwiderstand erfolgt.

Des Weiteren ist aus der Druckschrift DE 10 2004 055 849 A1 eine Batteriesensorvorrichtung mit einer unmittelbar an den Pol einer Kraftfahrzeugbatterie anschließbaren Befestigungsvorrichtung bekannt. Die Befestigungsvorrichtung ist mechanisch und elektrisch mit einem Trägerelement und einer Elektronikeinheit zur Erfassung von Batteriezustandsgrößen verbunden. Die Befestigungsvorrichtung und das Trägerelement sind einteilig ausgebildet und bestehen aus einem gemeinsamen Widerstandsmaterial. Das Trägerelement weist zwei in Stromflussrichtung örtlich beabstandete Anschlusspunkte auf, an denen die Elektronikeinheit elektrisch leitend befestigt ist, wobei der zwischen den Anschlusspunkten gebildete ohmsche Widerstand schaltungstechnisch in die Elektronikeinheit integriert ist. Das Widerstandsmaterial wird dabei in eine Ausnehmung im Trägerelement eingelegt.

Auch aus der Druckschrift DE 103 32 410 B3 ist eine Sensorvorrichtung für ein Bordnetz von Kraftfahrzeugen zur Erfassung von Strom, Spannung und/oder Temperatur bekannt. Die Sensorvorrichtung ist mit zwei Anschlussstücken an Strom führende Leitungen innerhalb des Bordnetzes angeschlossen, wobei ein Messwiderstand die beiden Anschlussstücke elektrisch verbindet. Eine kleinbauende, leicht integrierbare und formstabile Verbindung der Anschlussstücke wird dadurch erreicht, dass der Messwiderstand im Wesentlichen rotationssymmetrisch gebildet ist und zwischen den Anschlussstücken angeordnet ist. Ein derartiger Sensor wird vorzugsweise in Batterienähe angeordnet.

Allen Lösungen ist gemeinsam, dass die Sensoreinheit der Anschlusseinrichtungen an eine Batterie als Präzisionswiderstand (Shunt) bzw. als ganze Messeinheit vergleichsweise aufwändig integriert werden muss. Dazu sind separate Fügeverfahren, wie beispielsweise Schweiß- oder Lötverbindungen, nötig.

Der Erfindung liegt die Aufgabe zugrunde, ein elektrisches Leitermaterial anzugeben, bei dem ein Messwiderstand in einfacher Weise integriert ist. Ein weiterer Aspekt der Aufgabe ist, ein geeignetes Herstellungsverfahren zur Integration des Messwiderstandes anzugeben.

Die Erfindung wird bezüglich eines elektrischen Leitermaterials mit Messwiderstand durch die Merkmale des Anspruchs 1 und bezüglich eines Verfahrens zur Herstellung eines elektrischen Leitermaterials durch die Merkmale der Ansprüche 9 und 15 bis 17 wiedergegeben. Die weiteren rückbezogenen Ansprüche betreffen vorteilhafte Aus- und Weiterbildungen der Erfindung.

Die Erfindung schließt ein elektrisches Leitermaterial mit Messwiderstand ein, wobei der Messwiderstand mit dem übrigen Material des elektrischen Leiters als formschlüssiger Werkstoffverbund und/oder, bis auf die außen liegende Oberfläche, allseitig stoffschlüssig eingebunden ist, wobei im Betrieb der Stromfluss zumindest zum Teil über den Messwiderstand führt.

Die Erfindung geht dabei von der Überlegung aus, dass der Formschluss über die spezielle Geometrie des Messwiderstands hervorgerufen wird. Dieser kann als Inlay in Kupfer oder einer Kupferlegierung als Vollmaterial eingebunden sein. Die Formgebung eines Inlays kann durch Strangpressen vorgegeben werden. Üblicherweise werden dazu Inlays mit zapfenförmigen Ausbuchtungen mit sich verbreiterten Enden massiv oder auch in Form von Bändern hergestellt. Bandförmige Inlays werden an oder nahe der Oberfläche angeordnet. Dabei kann auch Bandmaterial mit Formschluss, beispielsweise in Form einer omegaförmigen Ausbuchung an den Enden des Inlays, verwendet werden. Jedoch können auch massive Inlays mit einem oder mehreren Löchern in entsprechender Form ausgestaltet werden. So sind im Verbund mit Kupfer oder einer Kupferlegierung die Ausbuchtungen umschlossen bzw. die Löcher ausgefüllt. Ein Inlay kann zunächst auch komplett oder teilweise eingebettet sein und wird gegebenenfalls durch eine Nachbearbeitung freigelegt.

Der Formschluss kann durch mechanisches Fügen hergestellt werden, indem das Inlay durch Kalt-, Halbwarm- oder Warmumformen mit einer oder mehreren Anschlusskomponenten formschlüssig verbunden wird. Dabei werden die Anschlusskomponenten aus Kupfer oder einer Kupferlegierung entsprechend umgeformt.

Der besondere Vorteil besteht darin, dass durch die erfindungsgemäße stoffschlüssige und/oder formschlüssige Verbindung mit dem Umgebungsmaterial für die Inlays keines der sonst üblichen thermischen Fügeverfahren, wie beispielsweise das Aneinanderschweißen der Einzelkomponenten, benötigt wird.

In bevorzugter Ausführungsform ist das elektrische Leitermaterial als Anschlusseinrichtung an eine Batterie mit einer direkt an einen Pol der Batterie anschließbaren Befestigungseinrichtung und mit einem an einer Messeinrichtung anschließbaren Messwiderstand ausgebildet. Die unmittelbare Integration des Messwiderstandes in eine Batterieklemme bildet eine robuste und wenig störanfällige Lösung für den Automotivbereich.

In bevorzugter Ausgestaltung der Erfindung kann zwischen dem Messwiderstand und dem übrigen Material der Anschlusseinrichtung zumindest partiell eine Zwischenschicht angeordnet sein. Vorteilhafterweise kann die Zwischenschicht eine Silber- oder Silberlegierungsschicht und/oder eine Isolationsschicht sein. Über Zwischenschichten können auf dieser Basis auch Diffusionszwischenschichten erzeugt werden, die bereits im Herstellungsprozess durch entsprechende Temperaturen oder durch nachträgliches Tempern durch Anschmelzen der zusätzlichen Diffusionsschicht erzeugt werden.

Partiell aufgebrachte Isolationsschichten werden auf der Oberfläche eines Präzisionswiderstandes bevorzugt an den Seitenflächen entlang der Stromflussrichtung aufgebracht und die endständigen Flächen zur Kontaktierung mit dem übrigen Material der Anschlusseinrichtung genutzt.

In bevorzugter Ausführungsform der Erfindung kann der Messwiderstand aus einer Kupferlegierung der Zusammensetzung 82 - 86 Gew.-% Cu, 10 - 15 Gew.-% Mn und 1 - 4 Gew.-% Ni, wahlweise 0,005 - 0,5 Gew.-% Sn sowie unvermeidbare Verunreinigungen bestehen. Bei Kupfer-Mangan-Nickel-Legierungen derartiger Zusammensetzungen handelt es sich um Widerstandslegierungen mit einem Schmelzpunkt um 960 °C und mit einem mittleren spezifischen elektrischen Widerstand von etwa 4,3·10⁻⁷ Ωm und einem geringen linearen Temperaturkoeffizienten im Bereich von α = 0,02·10⁻³ K⁻¹. Auf Grund der geringen Temperaturabhängigkeit werden derartige Legierungen bereits als Messwiderstand, beispielsweise bei der Vier-Punkt-Methode, eingesetzt.

Alternativ kann vorteilhafterweise der Messwiderstand aus einer Kupferlegierung der Zusammensetzung 12 - 16 Gew.-% Zn, 12 - 16 Gew.-% Mn und 0,5 - 5 Gew.-% Al, wahlweise 0,005 - 0,5 Gew.-% Fe, Rest Cu sowie unvermeidbare Verunreinigungen bestehen. Diese Legierung hat einen Schmelzbereich von ungefähr 840 bis 895 °C.

In bevorzugter Ausführungsform kann das übrige Material der Anschlusseinrichtung aus einer Kupferlegierung der Zusammensetzung 72,0 - 76,0 Gew.-% Cu, 2,5 - 4,0 Gew.-% Si, 0,01 - 0,25 Gew.-% P, Rest Zn und wahlweise 0,0001 - 0,5 Gew.-% Zr sowie unvermeidbare Verunreinigungen bestehen. Hierbei handelt es sich um bleifreies Messing als hochbelastbares Sondermessing mit guter Korrosionsbeständigkeit und sehr guter Zerspanbarkeit. Dabei wird, insbesondere durch eine Zugabe von Silizium, die Anlaufbeständigkeit erhöht und die Empfindlichkeit auf Spannungsrisskorrosion stark vermindert. Der Schmelzbereich dieser Legierung liegt bei 860 bis 925 °C.

Alternativ kann vorteilhafterweise das übrige Material der Anschlusseinrichtung aus einer Kupferlegierung der Zusammensetzung [Gew.-%]
72,0 - 76,0 % Cu,
2,5 - 4,0 % Si,
0,01 - 0,25 % P,
0,01 - 2 % Sn,
0,01 - 0,3 % Fe und/oder Co,
0,01 - 0,3 % Ni,
0,01 - 0,3 % Mn, und
wahlweise bis 0,5 Gew.-% Zr
wahlweise bis 0,5 % zumindest eines der Elemente Ag, Al, As, Mg, Sb, Ti, Rest Zn und unvermeidbare Verunreinigungen bestehen.

Diese Kupferlegierung gehört zu den Sondermessingen ohne toxische Zusätze. Die Legierung ist in der angegebenen Zusammensetzung problemlos fertigbar und überraschend konstant in den Eigenschaften. Dies ist bei ternären Legierungen Cu-Zn-Si, wie sie üblicherweise in der Literatur behandelt werden, oft nicht gegeben. Ihnen fehlen die günstigen Eigenschaften im Strangguss und eine stabile, von Schwankungen der Betriebsparameter, beispielsweise beim Strangpressen, wenig abhängige Gefügebildung. Es zeigt sich, dass die Schwankungsbreite in ihren Eigenschaften in erster Näherung vom Gehalt der matrixaktiven Elemente abhängt. Auf Basis der Majoritätskomponenten Cu, Zn und Si, ist der Gehalt in Summe an den in der Matrix zumindest teilweise löslichen matrixaktiven Elementen P, Sn, Fe, Co, Ni und Mn allein oder in Verbindung mit den Wahlelementen Ag, Al, As, Mg, Sb, Ti und Zr offenbar von entscheidender Bedeutung für die robuste, gegen schwankende Betriebsparameter unempfindliche Fertigung im Halbzeugwerk. Zr kann bei derartigen Sondermessingen zur Kornfeinung hinzu gegeben werden. Aus der geeigneten Kombination der Legierungselemente und die aus einem Zusammenwirken der Einzelbestandteile resultierenden Eigenschaften in ihrer Gesamtheit werden die an die Legierung gestellten Erwartungen erfüllt.

Ein weiterer Aspekt der Erfindung schließt ein Verfahren zur Herstellung eines elektrischen Leitermaterials mit Messwiderstand ein, bestehend aus einer in einem Schmelzbereich mehrphasig vorliegenden ersten Kupferlegierung und einer zweiten Kupferlegierung, wobei der Messwiderstand, bestehend aus der zweiten Kupferlegierung, durch das übrige Material des elektrischen Leiters, bestehend aus der im teilflüssigen Zustand befindlichen ersten Kupferlegierung, formschlüssig und/oder, bis auf die außen liegende Oberfläche, allseitig stoffschlüssig eingebunden wird. Mehrphasig bedeutet, dass die Kupferlegierung bei Temperaturen im Schmelzbereich teilflüssig ist und dabei sowohl einen festen als auch einen flüssigen Phasenanteil aufweist.

In weiterer vorteilhafter Ausgestaltung der Erfindung kann der Messwiderstand, bestehend aus der höher schmelzenden zweiten Kupferlegierung, mittels Thixo-Schmieden oder Thixo-Druckguss eingebunden werden.

Im Gegensatz zu sonstigen umformtechnischen Verfahren kann ein Formschluss durch ein so genanntes Urformverfahren erzeugt werden. In Betracht hierbei kommen konventionelle Verfahren wie Sandguss, Druckguss oder Thixo-Druckguss. Beim Thixo-Druckgießen wird die Schmelze aus einem Gießtiegel entnommen und nach kontrollierter Abkühlung bei Legierungen im teilflüssigen Zustand des Zweiphasengebiets verarbeitet.

Ein innerhalb des Thixo-geschmiedeten Teiles oder des Gussteiles wird durch einen nachfolgenden Bearbeitungsschritt ein zunächst nach dem Herstellungsprozess eingebettetes Inlay durch spanabhebende Verfahren freigelegt. Hierbei wird der Querschnitt in Abhängigkeit des vorhandenen elektrischen Widerstandes des Rohteiles derart eingestellt, dass der Widerstand des Verbund-Fertigteiles innerhalb der vorgegebenen Toleranzen liegt.

Vorteilhafterweise kann die erste Kupferlegierung aus der Zusammensetzung 72,0 - 76,0 Gew.-% Cu, 2,5 - 4,0 Gew.-% Si, 0,01 - 0,25 Gew.-% P, Rest Zn und wahlweise 0,0001 - 0,5 Gew.-% Zr sowie unvermeidbare Verunreinigungen bestehen.

Alternativ kann die erste Kupferlegierung vorteilhafterweise auch aus der Zusammensetzung [Gew.-%]
72,0 - 76,0 % Cu,
2,5 - 4,0 % Si,
0,01 - 0,25 % P,
0,01 - 2 % Sn,
0,01 - 0,3 % Fe und/oder Co,
0,01 - 0,3 % Ni,
0,01 - 0,3 % Mn, und
wahlweise bis 0,5 Gew.-% Zr
wahlweise bis 0,5 % zumindest eines der Elemente Ag, Al, As, Mg, Sb, Ti, Rest Zn und unvermeidbare Verunreinigungen bestehen.

Beide Legierungstypen zeichnen sich im Verfahren durch einen Schmelzbereich aus, in dem die Legierung zweiphasig vorliegt und damit ideal für das Thixo-Umformen ist.

In weiterer Ausgestaltung der Erfindung kann die zweite Kupferlegierung aus der Zusammensetzung 82 - 86 Gew.-% Cu, 10 - 15 Gew.-% Mn und 1 - 4 Gew.-% Ni und wahlweise 0,005 - 0,5 Gew.-% Sn sowie unvermeidbare Verunreinigungen bestehen.

Vorteilhafterweise kann auch, insbesondere im Zusammenhang mit Thixo-Schmieden oder Thixo-Druckguss, die zweite Kupferlegierung aus der Zusammensetzung 12-16 Gew.-% Zn, 12 - 16 Gew.-% Mn und 1 - 5 Gew.-% Al, wahlweise 0,005 - 0,5 Gew.-% Fe, Rest Cu sowie unvermeidbare Verunreinigungen bestehen. Diese Legierung ist mit einem etwas niedrigeren Schmelzbereich um etwa 840 bis 895 °C für besonders schnell ablaufende Verfahren mit hoher Abkühlrate geeignet.

Ein alternativer Aspekt der Erfindung schließt ein Verfahren zur Herstellung eines elektrischen Leitermaterials mit Messwiderstand, bestehend aus einer ersten Kupferlegierung und einer zweiten Kupferlegierung, wobei der Messwiderstand, bestehend aus der zweiten Kupferlegierung, im festen Zustand durch das übrige Material des elektrischen Leiters, bestehend aus der ersten Kupferlegierung, mittels Kalt- oder Warmumformung formschlüssig eingebunden wird.

Ein weiterer alternativer Aspekt der Erfindung schließt ein Verfahren zur Herstellung eines elektrischen Leitermaterials mit Messwiderstand ein, bestehend aus einer ersten Kupferlegierung und einer zweiten Kupferlegierung, wobei der Messwiderstand, bestehend aus der zweiten Kupferlegierung, durch das übrige Material des elektrischen Leiters, bestehend aus der ersten Kupferlegierung, partiell oder vollständig durch Einwalzen formschlüssig und/oder, bis auf die außen liegende Oberfläche, allseitig stoffschlüssig eingebunden wird.

Ein weiterer alternativer Aspekt der Erfindung schließt ein Verfahren zur Herstellung eines elektrischen Leitermaterials mit Messwiderstand ein, bestehend aus einer ersten Kupferlegierung und einer zweiten Kupferlegierung, wobei der Messwiderstand, bestehend aus der zweiten Kupferlegierung, durch das übrige Material des elektrischen Leiters, bestehend aus der ersten Kupferlegierung partiell oder vollständig durch Eingießen formschlüssig und/oder, bis auf die außen liegende Oberfläche, allseitig stoffschlüssig eingebunden wird.

In vorteilhafter Ausgestaltung der Erfindung kann zumindest auf einem Teil der Oberfläche des Messwiderstandes, bestehend aus der zweiten Kupferlegierung, vor dem Einbinden in die erste Kupferlegierung zumindest partiell eine Zwischenschicht aus Silber, einer Silberlegierung und/oder eine Isolationsschicht aufgebracht werden.

Ausführungsbeispiele der Erfindung werden anhand einer schematischen Zeichnung näher erläutert.

Darin zeigen:
- Fig. 1: eine Batterieklemme mit einem form- und stoffschlüssig eingebundenen Messwiderstand,
- Fig. 2: eine Batterieklemme mit einem Messwiderstand mit mittigem Loch, und
- Fig. 3: eine weitere Ausführungsform einer Batterieklemme mit einem form- und stoffschlüssig eingebundenen Messwiderstand.

Einander entsprechende Teile sind in allen Figuren mit denselben Bezugszeichen versehen.

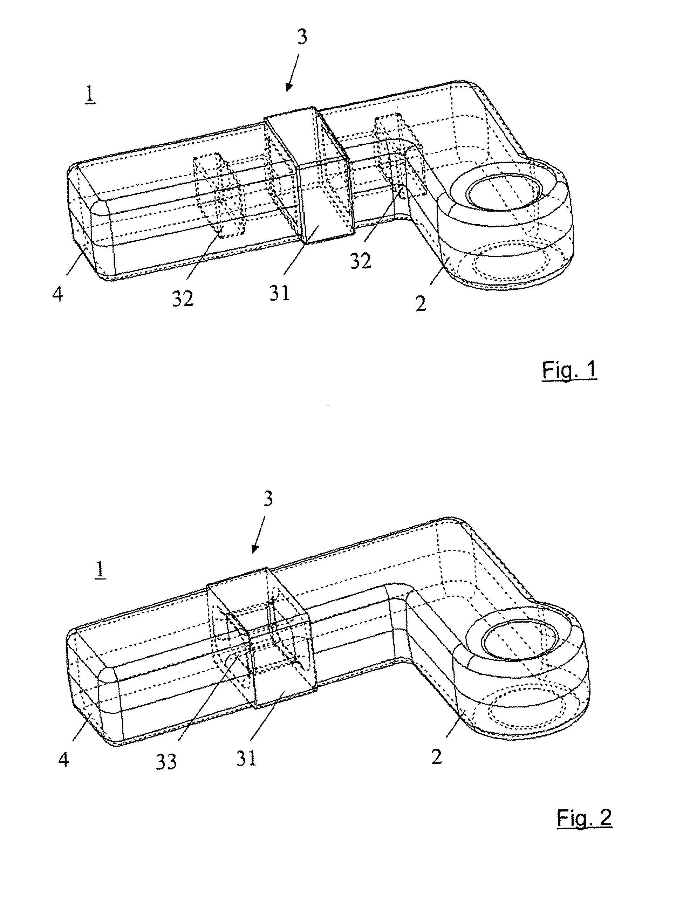

Fig. 1 zeigt eine Batterieklemme 1 als erfindungsgemäße Anschlusseinrichtung mit einem form- und stoffschlüssig eingebundenen Messwiderstand 3.

Die Batterieklemme 1 wird an eine Batterie mit einer zum Polschuh passenden Befestigungseinrichtung 2, hier als ringförmige Öse ausgebildet, direkt an die Batterie angeschlossen. Die Messeinrichtung für den Messwiderstand 3 und die Batterie ist in der Fig. 1 nicht dargestellt. Der Messwiderstand 3 bildet mit dem übrigen Material der Batterieklemme 1 durch zwei mittig angeordnete ambossförmige Fortsätze 32 einen formschlüssigen Werkstoffverbund aus. Zudem wird, beispielsweise durch Thixoforming, bis auf die außen liegende Oberfläche des Messwiderstands 31, ein allseitiger Stoffschluss hergestellt. Im Betrieb fließt in diesem Fall der gesamte Strom über den Messwiderstand 3. Das von der nicht dargestellten Batterie abgewandte zweite Ende der Batterieklemme 1 dient als Kabelanschluss 4.

Fig. 2 zeigt eine Batterieklemme 1 mit einem Messwiderstand 3 mit mittigem Loch als Ausnehmung 33. In diesen Fällen teilt sich der Stromfluss im Bereich des Messwiderstandes 3 in den unterschiedlichen Materialien entsprechend auf. Diese Ausführungsform hat, insbesondere bei der Verwendung von Gießverfahren zur Herstellung der Batterieklemme 1, den Vorteil, dass das mittige Loch des Messwiderstandes 3 ohne weiteres mit dem übrigen Material gefüllt werden kann.

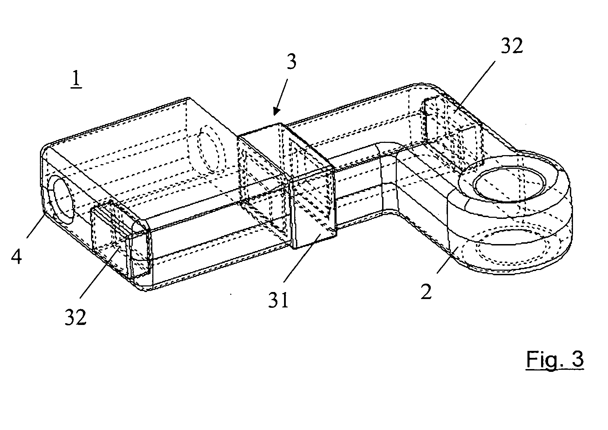

Fig. 3 zeigt eine weitere Ausführungsform einer Batterieklemme 1 mit einem form- und stoffschlüssig eingebundenen Messwiderstand 3. Der Bereich des Kabelanschlusses 4 hat eine Bohrung zur einfachen Befestigung des Kabels.

### Bezugszeichenliste

- 1: Anschlusseinrichtung; Batterieklemme
- 2: Befestigungseinrichtung
- 3: Messwiderstand; Inlay aus Cu-Mn-Ni-Legierung
- 31: Außen liegende Oberfläche des Messwiderstands
- 32: Ambossförmiger Fortsatz des Messwiderstands
- 33: Ausnehmung
- 4: Kabelanschluss

## Patentansprüche

1. Elektrisches Leitermaterial mit Messwiderstand (3), **dadurch gekennzeichnet, dass** der Messwiderstand (3) mit dem übrigen Material des elektrischen Leiters als formschlüssiger Werkstoffverbund und/oder, bis auf die außen liegende Oberfläche (31), allseitig stoffschlüssig eingebunden ist, wobei im Betrieb der Stromfluss zumindest zum Teil über den Messwiderstand (3) führt.

2. Elektrisches Leitermaterial nach Anspruch 1, **dadurch gekennzeichnet, dass** es als Anschlusseinrichtung (1) an eine Batterie mit einer direkt an einen Pol der Batterie anschließbaren Befestigungseinrichtung (2) und mit einem an einer Messeinrichtung anschließbaren Messwiderstand (3) ausgebildet ist.

3. Elektrisches Leitermaterial nach Anspruch 1 oder 2, **dadurch gekennzeichnet, dass** zwischen dem Messwiderstand (3) und dem übrigen Material des elektrischen Leiters zumindest partiell eine Zwischenschicht angeordnet ist.

4. Elektrisches Leitermaterial nach einem der Ansprüche 1 bis 3, **dadurch gekennzeichnet, dass** die Zwischenschicht eine Silber- oder Silberlegierungsschicht und/oder eine Isolationsschicht ist.

5. Elektrisches Leitermaterial nach einem der Ansprüche 1 bis 4, **dadurch gekennzeichnet, dass** der Messwiderstand (3) aus einer Kupferlegierung der Zusammensetzung 82 - 86 Gew.-% Cu, 10 - 15 Gew.-% Mn und 1 - 4 Gew.-% Ni, wahlweise 0,005 - 0,5 Gew.-% Sn sowie unvermeidbare Verunreinigungen besteht.

6. Elektrisches Leitermaterial nach einem der Ansprüche 1 bis 4, **dadurch gekennzeichnet, dass** der Messwiderstand (3) aus einer Kupferlegierung der Zusammensetzung 12 - 16 Gew.-% Zn, 12 - 16 Gew.-% Mn und 0,5 - 5 Gew.-% Al, wahlweise 0,005 - 0,5 Gew.-% Fe, Rest Cu sowie unvermeidbare Verunreinigungen besteht.

7. Elektrisches Leitermaterial nach einem der Ansprüche 1 bis 6, **dadurch gekennzeichnet, dass** das übrige Material des elektrischen Leiters aus einer Kupferlegierung der Zusammensetzung 72,0 - 76,0 Gew.-% Cu, 2,5 - 4,0 Gew.-% Si, 0,01 - 0,25 Gew.-% P, Rest Zn und wahlweise 0,0001 - 0,5 Gew.-% Zr sowie unvermeidbare Verunreinigungen besteht.

8. Elektrisches Leitermaterial nach einem der Ansprüche 1 bis 6, **dadurch gekennzeichnet, dass** das übrige Material des elektrischen Leiters aus einer Kupferlegierung besteht mit der Zusammensetzung [Gew.-%]
72,0 - 76,0 % Cu,
2,5 - 4,0 % Si,
0,01 - 0,25 % P,
0,01 - 2 % Sn,
0,01 - 0,3 % Fe und/oder Co,
0,01 - 0,3 % Ni,
0,01 - 0,3 % Mn, und
wahlweise bis 0,5 Gew.-% Zr
wahlweise bis 0,5 % zumindest eines der Elemente Ag, Al, As, Mg, Sb, Ti, Rest Zn und unvermeidbare Verunreinigungen.

9. Verfahren zur Herstellung eines elektrischen Leitermaterials mit Messwiderstand (3), bestehend aus einer in einem Schmelzbereich mehrphasig vorliegenden ersten Kupferlegierung und einer zweiten Kupferlegierung,
**dadurch gekennzeichnet, dass** der Messwiderstand (3), bestehend aus der zweiten Kupferlegierung, durch das übrige Material des elektrischen Leiters, bestehend aus der im teilflüssigen Zustand befindlichen ersten Kupferlegierung formschlüssig und/oder, bis auf die außen liegende Oberfläche (31), allseitig stoffschlüssig eingebunden wird.

10. Verfahren zur Herstellung eines elektrischen Leitermaterials nach Anspruch 9, **dadurch gekennzeichnet, dass** der Messwiderstand (3), bestehend aus der zweiten Kupferlegierung, mittels Thixo-Schmieden oder Thixo-Druckguss eingebunden wird.

11. Verfahren zur Herstellung eines elektrischen Leitermaterials nach Anspruch 9 oder 10, **dadurch gekennzeichnet, dass** die erste Kupferlegierung aus der Zusammensetzung 72,0 - 76,0 Gew.-% Cu, 2,5 - 4,0 Gew.-% Si, 0,01 - 0,25 Gew.-% P, Rest Zn und wahlweise 0,0001 - 0,5 Gew.-% Zr sowie unvermeidbare Verunreinigungen besteht.

12. Verfahren zur Herstellung eines elektrischen Leitermaterials nach Anspruch 9 oder 10, **dadurch gekennzeichnet, dass** die erste Kupferlegierung aus der Zusammensetzung [Gew.-%]
72,0 - 76,0 % Cu,
2,5 - 4,0 % Si,
0,01 - 0,25 % P,
0,01 - 2 % Sn,
0,01 - 0,3 % Fe und/oder Co,
0,01 - 0,3 % Ni,
0,01 - 0,3 % Mn, und
wahlweise bis 0,5 Gew.-% Zr
wahlweise bis 0,5 % zumindest eines der Elemente Ag, Al, As, Mg, Sb, Ti, Rest Zn und unvermeidbare Verunreinigungen besteht.

13. Verfahren zur Herstellung eines elektrischen Leitermaterials nach einem der Ansprüche 9 bis 12, **dadurch gekennzeichnet, dass** die zweite Kupferlegierung aus der Zusammensetzung 82 - 86 Gew.-% Cu, 10-15 Gew.-% Mn und 1 - 4 Gew.-% Ni und wahlweise 0,005 - 0,5 Gew.-% Sn sowie unvermeidbare Verunreinigungen besteht.

14. Verfahren zur Herstellung eines elektrischen Leitermaterials nach einem der Ansprüche 9 bis 12, **dadurch gekennzeichnet, dass** die zweite Kupferlegierung aus der Zusammensetzung 12 - 16 Gew.-% Zn, 12 - 16 Gew.-% Mn und 1 - 5 Gew.-% Al, wahlweise 0,005 - 0,5 Gew.-% Fe, Rest Cu sowie unvermeidbare Verunreinigungen besteht.

15. Verfahren zur Herstellung eines elektrischen Leitermaterials mit Messwiderstand (3), bestehend aus einer ersten Kupferlegierung und einer zweiten Kupferlegierung, **dadurch gekennzeichnet, dass** der Messwiderstand (3), bestehend aus der zweiten Kupferlegierung, im festen Zustand durch das übrige Material des elektrischen Leiters, bestehend aus der ersten Kupferlegierung, mittels Kalt- oder Warmumformung formschlüssig eingebunden wird.

16. Verfahren zur Herstellung eines elektrischen Leitermaterials mit Messwiderstand (3), bestehend aus einer ersten Kupferlegierung und einer zweiten Kupferlegierung, **dadurch gekennzeichnet, dass** der Messwiderstand (3), bestehend aus der zweiten Kupferlegierung, durch das übrige Material des elektrischen Leiters, bestehend aus der ersten Kupferlegierung partiell oder vollständig durch Einwalzen formschlüssig und/oder, bis auf die außen liegende Oberfläche (31), allseitig stoffschlüssig eingebunden wird.

17. Verfahren zur Herstellung eines elektrischen Leitermaterials mit Messwiderstand (3), bestehend aus einer ersten Kupferlegierung und einer zweiten Kupferlegierung, **dadurch gekennzeichnet, dass** der Messwiderstand (3), bestehend aus der zweiten Kupferlegierung, durch das übrige Material des elektrischen Leiters, bestehend aus der ersten Kupferlegierung partiell oder vollständig durch Eingießen formschlüssig und/oder, bis auf die außen liegende Oberfläche (31), allseitig stoffschlüssig eingebunden wird.

18. Verfahren zur Herstellung eines elektrischen Leitermaterials nach einem der Ansprüche 9 bis 17, **dadurch gekennzeichnet, dass** zumindest auf einem Teil der Oberfläche des Messwiderstandes (3), bestehend aus der zweiten Kupferlegierung, vor dem Einbinden in die erste Kupferlegierung zumindest partiell eine Zwischenschicht (4) aus Silber, einer Silberlegierung und/oder eine Isolationsschicht aufgebracht wird.
